Europäisches Patentamt

European Patent Office

Office européen des brevets

(19)

(11) Veröffentlichungsnummer: **0 450 187 A1**

(12) # EUROPÄISCHE PATENTANMELDUNG

(21) Anmeldenummer: 90125199.1

(22) Anmeldetag: 21.12.90

(51) Int. Cl.5: **H05K 5/02**

(30) Priorität: 05.04.90 DE 4011074

(43) Veröffentlichungstag der Anmeldung:
**09.10.91 Patentblatt 91/41**

(84) Benannte Vertragsstaaten:
**CH DE FR GB IT LI**

(71) Anmelder: **BICC-VERO ELECTRONICS GMBH**
**Carsten-Dressler-Strasse 10**
**W-2800 Bremen 61(DE)**

(72) Erfinder: **Borschewski, Dietmar**
**Woltmershauserstrasse 287**

**W-2800 Bremen 1(DE)**
Erfinder: **Schröder, Rainer**
**Trelleborgerstrasse 14**
**W-2820 Bremen 77(DE)**
Erfinder: **Bösch, Peter**
**Oserstrasse 127**
**W-2800 Bremen 61(DE)**

(74) Vertreter: **Bohnenberger, Johannes, Dr. et al**
**Meissner, Bolte & Partner**
**Widenmayerstrasse 48 Postfach 86 06 24**
**W-8000 München 86(DE)**

(54) **Gehäuse, insbesondere Baugruppenträger.**

(57) Ein Gehäuse, insbesondere Baugruppenträger, mit zwei Seitenwänden, wenigstens einer oberen und einer unteren mit den beiden Seitenwänden verbundenen und diese zueinander auf Abstand haltenden Stützstreben oder dergleichen, und zwei, jeweils etwa senkrecht an der Außenseite einer jeden Seitenwand in einem stirnseitig nahen Bereich anbringbaren Befestigungsmittel, das an jeder Seitenwand (2) an ihrer Außenseite (5) im stirnseitig nahen Bereich (12) ein als Befestigunsmittel vorgesehenes Klappteil (14) aufweist.

FIG.1

Die Erfindung betrifft ein Gehäuse, insbesondere Baugruppenträger, nach dem Oberbegriff des Patentanspruchs 1.

Die bislang bekannt gewordenen Gehäuse, insbesondere Baugruppenträger, weisen in aller Regel zwei Seitenwände auf, die über eine obere und eine untere Deckplatte miteinander verbunden und hierdurch zueinander auf Abstand gehalten werden. Aus Gründen der Materialersparnis wie auch für eine leichtere Bauweise sind derartige Deckplatten oftmals durch Stützstreben ersetzt. So sind Ausführungsformen solcher Gehäuse bekannt, bei denen jeweils zwei obere und untere, zueinander auf Abstand gehaltene Stützstreben an der Innenseite der jeweiligen Seitenwand in deren stirn- bzw. rückseitig nahen Bereich angeordnet sind. Desweiteren sind aber auch Ausführungsformen derartiger Gehäuse bekannt, bei denen jeweils eine obere und untere, allerdings relativ breit ausgestaltete Stützstrebe an der Innenseite der jeweiligen Seitenwand etwa mittig angeordnet ist. Schließlich weisen derartige Gehäuse noch daran jeweils etwa senkrecht an der Außenseite einer jeden Seitenwand in deren stirnseitig nahen Bereich anbringbare Befestigungsmittel auf. Als derartige Befestigungsmittel sind in der Hauptsache herkömmliche, mit Bohrungen versehene L-förmige Winkel vorgesehen, die mittels Schrauben mit jeweils einem Schenkel an der Außenseite einer jeden Seitenwand im stirnseitig nahen Bereich und nach dem Einsetzen des Gehäuses bzw. Baugruppenträgers in ein Gestell oder dergleichen mit dem jeweils anderen Schenkel an einem Rahmen-, Wandteil oder ähnlichem des Gestells fixiert und/oder befestigt wird. Derartige L-förmige Winkel werden jedoch ausschließlich zur Montage des Gehäuses bzw. Baugruppenträgers in ein solches Gestell oder dergleichen sowie zu dessen Fixierung bzw. Befestigung an diesem Gestell benötigt. Soll hingegen das Gehäuse bzw. der Baugruppenträger beispielsweise nach dem Einbau in ein derartiges Gestell nachträglich als Tischgehäuse Verwendung finden, so sind die von der jeweiligen Seitenwand abstehenden, zudem gefährlichen und wenig formschönen L-förmig ausgebildeten Winkel zunächst wiederum gesondert zu lösen. Dabei hat sich in der Praxis gezeigt, daß diese L-förmig ausgebildeten Winkel oftmals nach einiger Zeit der Aufbewahrung verlustig gehen, so daß dann eine erneute Montage des Gehäuses oder Baugruppenträgers in einem Gestell nurmehr nach Beschaffung von Ersatz solcher Winkel möglich ist. Ein sofortiger Einbau des Gehäuses, das zunächst als Tischgehäuse vorgesehen war, in ein Gestell oder dergleichen ist ebenso nur möglich, wenn solche L-förmig ausgestalteten Winkel vorhanden sind. Diese sind jedoch nicht immer umgehend lieferbar.

Der Erfindung liegt daher die Aufgabe zugrunde, ein Gehäuse , insbesondere einen Baugruppenträger, gemäß dem Oberbegriff des Patentanspruchs 1 derart auszugestalten, daß das Gehäuse in Folge einer einfachen, wenig aufwendigen und zugleich kostengünstigen Konstruktion sowohl als formschönes Tischgehäuse wie auch als ein in ein Gestell oder dergleichen zu montierendes Gehäuse schnell und ohne zusätzliche Umbaumaßnahmen verwendbar ist.

Diese Aufgabe wird durch die im Kennzeichen des Patentanspruches 1 genannten Merkmale gelöst.

Durch die erfindungsgemäße Ausgestaltung läßt sich das Gehäuse gleichzeitig sowohl als Tischgehäuse wie auch als ein in ein Gestell oder dergleichen einzusetzendes Gehäuse verwenden. Sofern nämlich das Gehäuse als einzelnes Tischgehäuse Verwendung finden soll, lassen sich einerseits die Klappteile jeweils an der Außenseite einer jeden Seitenwand anlegen. Soll das erfindungsgemäße Gehäuse jedoch auch als in einem Gestell oder dergleichen zu montierendes Gehäuse eingesetzt werden, lassen sich andererseits die Klappteile ohne jeglichen zusätzlichen Montageaufwand von der Außenseite einer jeden Seitenwand wegklappen und hiernach mittels Schrauben an einem Rahmen- oder Wandteil des das Gehäuse insgesamt aufnehmenden Gestells ohne jegliche Anstrengung befestigen. Auf diese Weise läßt sich der Umbau vom Tischgehäuse in ein in ein Gestell anzubringendes Gehäuse u.u. einfach und schnell erreichen. Zudem sind die Klappteile mit dem Gehäuse an dessen jeweiliger Seitenwand unverlierbar gehalten, so daß ein solcher Umbau zu jedem beliebigen Zeitpunkt stattfinden kann.

Weiterhin ist erfindungsgemäß vorgesehen, daß das Klappteil jeweils in einer an der Außenseite der jeweiligen Seitenwand vorgesehenen Ausnehmung versenkbar aufgenommen ist. Durch eine solche Ausgestaltung läßt sich ein einfaches und schnelles Einsetzen des Gehäuses bzw. Baugruppenträgers in das vorgesehene Gestell noch zusätzlich erreichen, da auf diese Weise das Klappteil wie auch die Außenseite der zugehörigen Seitenwand keinerlei Vorsprünge und ähnliches aufweisen. Ein Anstoßen oder gar Hängenbleiben der Außenseite der jeweiligen Seitenwand an den Rahmen- oder Wandteilen des Gestells kann auf diese Weise vollkommen ausgeschlossen werden. Außerdem läßt sich durch diese Maßnahme das Gehäuse mit gänzlich in einer Ausnehmung aufgenommenen, eingeklappten Klappteilen als ausgesprochen formschönes Tischgehäuse ohne ab- bzw. hervorstehende, zudem oftmals gefährliche Teile ausbilden. Gleichzeitig stellt die Herstellung eines solch ausgestalteten Gehäuses keinerlei Schwierigkeit dar, da zusätzliche Scharniere oder sonstige Aufhängungsvorrichtungen für das Klappteil durch das nach Innen verlegen in die Ausnehmung der jeweiligen Seitenwand nicht erforderlich sind.

In weiterer Ausgestaltung der Erfindung ist vorgesehen, daß das Klappteil jeweils einteilig ausgebildet ist und einen Trag- sowie Befestigungsteil aufweist. Insbesondere ist das Gehäuse derart ausgebildet, daß der Tragteil jeweils aus einem etwa parallel zur Stirnseite der jeweiligen Seitenwand verlaufenden und mit einer Längsbohrung versehenen Wulst und der Befestigungsteil jeweils aus einer sich hieran anschließenden, zur Rückseite der jeweiligen Seitenwand verlaufenden und mit wenigstens einer Querbohrung versehenen Flachseite besteht. Sowohl durch eine derartige Einteiligkeit wie auch durch eine solche einfache, konstruktive Ausgestaltung des erfindungsgemäßen Klappteils läßt sich eine besonders wirtschaftliche Herstellungsweise des Gehäuses bzw. des Baugruppenträgers insgesamt erreichen.

Nach einem weiteren Merkmal der Erfindung ist das Klappteil jeweils über einen in die Längsbohrung des Tragteils durchsteckbaren Bolzens in der Ausnehmung der jeweiligen Seitenwand verschwenkbar gehalten. Besonders vorteilhaft läßt sich dies konstruktiv in der Weise bewerkstelligen, daß die aus dem Tragteil herausstehenden Enden des jeweiligen Bolzens in einer oberen und einer unteren, von der Ausnehmung der jeweiligen Seitenwand ausgehende Bohrung einsteckbar sind. Durch diese besonderen Maßnahmen läßt sich ohne großen konstruktiven Aufwand ein Gehäuse bzw. ein Baugruppenträger erhalten, der den Anforderungen sowohl im Hinblick auf die Wirtschaftlichkeit als auch im Hinblick auf die Funktionstüchtigkeit bzw. -sicherheit eines solch einfach zu handhabenden und zu montierenden Gehäuses bzw. Baugruppenträgers in besonderem Maße gerecht wird. Mit Ausnahme des jeweiligen Bolzens, der in die Längsbohrung des Tragteils eines jeden Klappteils hindurchgesteckt wird, sind weitere Drehgelenke oder dergleichen nämlich nicht notwendig. Auch läßt sich die Lagerung der aus dem Tragteil herausstehenden Enden des jeweiligen Bolzens auf einfache Weise dadurch realisieren, daß die Enden von Bohrungen, die in der Ausnehmung der jeweiligen Seitenwand vorgesehen sind, aufgenommen werden.

Es liegt weiter im Rahmen der Erfindung, die Bohrungen in der Ausnehmung der jeweiligen Seitenwand einerseits als Sackbohrung, andererseits als Durchgangsbohrung auszuführen. Dies hat den besonderen Vorteil, daß die beiden der Aufnahme und als Lager für die aus dem Tragteil herausstehenden Enden des jeweiligen Bolzens dienenden Bohrungen in einem einzigen Arbeitsgang erhalten werden können. Desweiteren läßt sich aber auch auf diese Weise erreichen, daß das Klappteil mit einem solchen zusätzlichen Bolzen in der Ausnehmung der jeweiligen Seitenwand dreh- und klappbar angebracht werden kann. Zur Montage des erfindungsgemäßen Klappteils wird dieses jeweils in die Ausnehmung der jeweiligen Seitenwand eingelegt, der jeweilige Bolzen sodann durch die Durchgangsbohrung der jeweiligen Seitenwand, die Längsbohrung des jeweiligen Klappteils und schließlich in die Sackbohrung der jeweiligen Seitenwand an gegenüberliegender Stelle in der Ausnehmung hindurch- bzw. eingesteckt, und letztendlich zur Halterung des jeweiligen Bolzens die Durchgangsbohrung der entsprechenden Seitenwand durch geeignete Mittel, beispielsweise durch Verschweißen, Verschrauben und ähnlichem, wiederum verschlossen werden.

Durch die erfindungsgemäße Ausbildung des Gehäuses bzw. des Baugruppenträgers, nämlich das Klappteil jeweils über eine durch die Querbohrung des Befestigungsteils durchsteckbare Schraube oder dergleichen mit einem das Gehäuse aufnehmenden Rahmen- oder Wandteil oder ählichem zu verbinden, läßt sich eine sichere Halterung des gesamten Gehäuses bzw. Baugruppenträgers z.B. innerhalb eines Gestells oder dergleichen an seinen Rahmen- oder Wandteilen eben über das jeweils an der Außenseite der entsprechenden Seitenwand drehbar gelagerte erfindungsgemäße Klappteil erreichen.

In weiterer Ausgestaltung der Erfindung ist das Klappteil jeweils zusammen mit dessen Längs- und/oder Querbohrung/en stranggepreßt, wodurch die Herstellung eines solchen Klappteils nicht nur kostengünstiger wird, sondern sich in gleichem Maße ausgesprochen gut für dessen Massenproduktion eignet.

Im Rahmen der Erfindung ist das Gehäuse bzw. der Baugruppenträger derart ausgestaltet, daß die Außenseite des Klappteils jeweils mit der Außenseite der jeweiligen Seitenwand fluchtet. Durch diese Maßnahme ist ein einfaches, zugleich schnelles Einschieben des Gehäuses in ein dafür vorgesehenes Gestell oder dergleichen in jedem Fall sichergestellt, da keinerlei über die Außenseite der jeweiligen Seitenwand überstehende Vorsprünge vorhanden sind, die ein Einhaken oder auch Hängenbleiben an den Rahmen- und Wandteilen des Gestells oder dergleichen verursachen könnten. Weiterhin kann das Gehäuse mit eingeklappten Klappteil als förmschönes Tischgehäuse ohne unnötig hervorstehende, gefährliche Teile verwendet werden.

Schließlich ist erfindungsgemäß noch vorgesehen, die Ausnehmung der jeweiligen Seitenwand etwa der Form des darin aufgenommenen Klappteils anzupassen, so daß die jeweilige Seitenwand in Folge der entsprechenden Ausnehmung, die zwangsläufig eine Materialaussparung an dieser Stelle nach sich zieht, nicht unnötigerweise geschwächt wird.

Weitere Merkmale, Vorteile und Einzelheiten der Erfindung ergeben sich aus der nachfolgenden Beschreibung einiger bevorzugter Ausführungsformen der Erfindung sowie anhand der Zeichnungen. Hierbei zeigen:

Fig. 1    eine perspektivische Ansicht einer Ausführungsform des Gehäuses in verkleinerter Darstellung,

Fig. 2    eine teilweise abgebrochene perspektivische Ansicht einer anderen Ausführungsform des Gehäuses mit einem ausgeklappten Klappteil in vergrößerter Darstellung,

Fig. 3    einen teilweise abgebrochenen Längsschnitt durch die Seitenwand einer Ausführungsform des Gehäuses gemäß Linie III-III in Fig. 1,

Fig. 4    einen teilweise abgebrochenen Querschnitt durch die Seitenwand einer Ausführungsform des Gehäuses gemäß Linie IV-IV in Fig. 1, sowie

Fig. 5    einen teilweise abgebrochenen Querschnitt durch die Seitenwand einer anderen Ausführungsform des Gehäuses gemäß Linie IV-IV in Fig. 1.

Das Gehäuse 1 weist im wesentlichen einen rechten Teil und einen hierzu spiegelverkehrt angeordneten linken Teil auf, wobei sich die einzelnen Bauelemente nicht voneinander unterscheiden. Aus Zweckmäßigkeitsgründen sind daher die gleichen Bezugsziffern für den rechten wie auch für den linken Teil des Gehäuses 1 bzw. des Baugruppenträgers 1 gewählt.

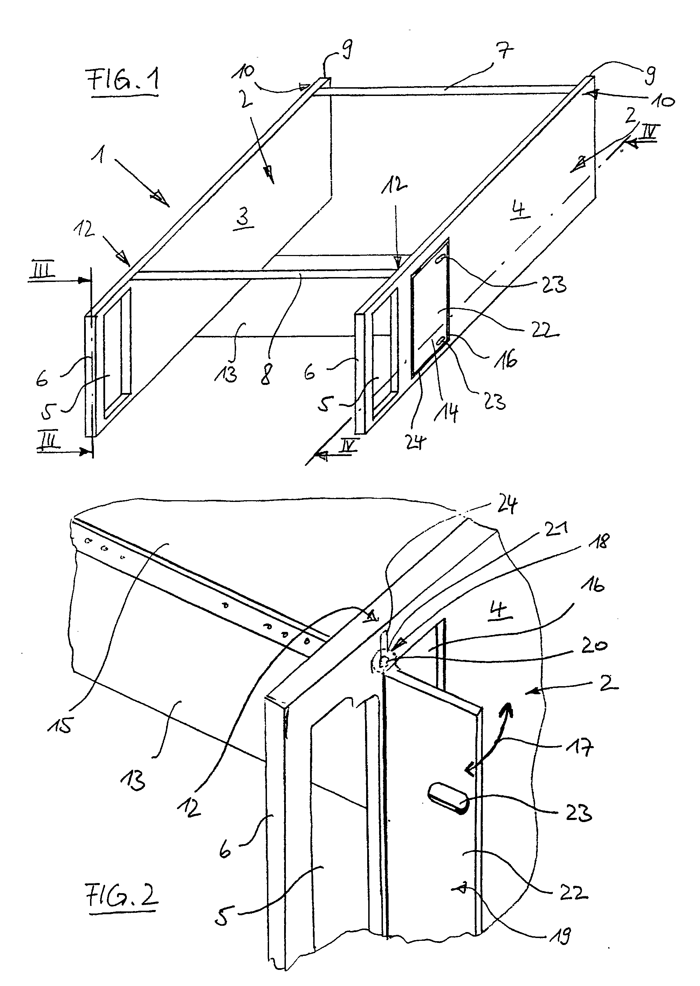

Das bzw. der in Fig. 1 dargestellte Gehäuse 1 bzw. Baugruppenträger 1 besteht aus zwei Seitenwänden 2, wobei jede der Innenseiten 3 der beiden Seitenwände 2 zueinander zugewandt, jede der Außenseiten 4 der beiden Seitenwände 2 voneinander abgewandt sind. Desweiteren sind Formgriffe 5 an jeder der beiden Seitenwände 2 nahe einer jeden Stirnseite 6 vorgesehen. Die beiden Seitenwände 2 sind mit zwei oberen Stützstreben 7, 8 miteinander verbunden und durch diese zueinander auf Abstand gehalten. Die obere Stützstrebe 7 ist hierbei jeweils an den Innenseiten 3 der beiden Seitenwände 2 nahe deren Rückseiten 9, d.h. im rückseitig nahen Bereich 10, die obere Stützstrebe 8 dagegen jeweils an den Innenseiten 3 der beiden Seitenwände 2 nahe deren Stirnseiten 6, d.h. im stirnseitig nahen Bereich 12, befestigt. Desweiteren ist die untere Stützstrebe 13 vorgesehen, die im Gegensatz zu den beiden oberen Stützstreben 7, 8 einerseits etwas breiter ausgestaltet, andererseits jeweils an den Innenseiten 3 der beiden Seitenwände 2 mittig angeordnet ist. Auch die untere Stützstrebe 13 verbindet somit die beiden Seitenwände 2 und hält diese zueinander auf Abstand.

Schließlich ist jeweils etwa senkrecht an den Außenseiten 4 einer jeden Seitenwand 2 ein Klappteil 14 in dem stirnseitig nahen Bereich 12 der Seitenwände 2 angeordnet, wobei in vorliegender Darstellung das Klappteil 14 der linken Seitenwand 2 mit all seinen Einzelbestandteilen nicht sichtbar ist.

Demgegenüber unterscheidet sich das Gehäuse 1 bzw. der Baugruppenträger 1 nach Fig. 2 von demjenigen gemäß Fig. 1 dadurch, daß anstatt der beiden oberen Stützstreben 7, 8 eine obere Deckplatte 15 zwischen den beiden Seitenwänden 2 angeordnet ist. Das Klappteil 14 ist, ebenso wie der Formgriff 5, dem stirnseitig nahen Bereich 11 zugeordnet. Das Klappteil 14, das in Fig. 2 etwa senkrecht zur Seitenwand 2 aufgeklappt dargestellt ist, ist weiterhin in einer an der Außenseite 4 der Seitenwand 2 vorgesehenen Ausnehmung 16 aufgenommen und in dieser entsprechend Pfeil 17 drehbar gelagert. Das Klappteil 14 läßt sich jedoch ebenso in der Ausnehmung 16 vollständig versenken. Das einteilig ausgebildete Klappteil 14 besteht hierbei aus einem Tragteil 18 - hier nur strichliert angedeutet - sowie einem Befestigungsteil 19. Das Tragteil 18 besteht seinerseits aus einem etwa parallel zur Stirnseite 6 der Seitenwand 2 verlaufenden und mit einer Längsbohrung 20 versehenen Wulst 21. Der Befestigungsteil 19 wird hingegen aus einer Flachseite 22 gebildet, die sich an den Wulst 21 anschließt, zur Rückseite 9 der Seitenwand 2 verläuft und mit wenigstens einer Querbohrung 23, hier in Form eines Langloches, versehen ist.

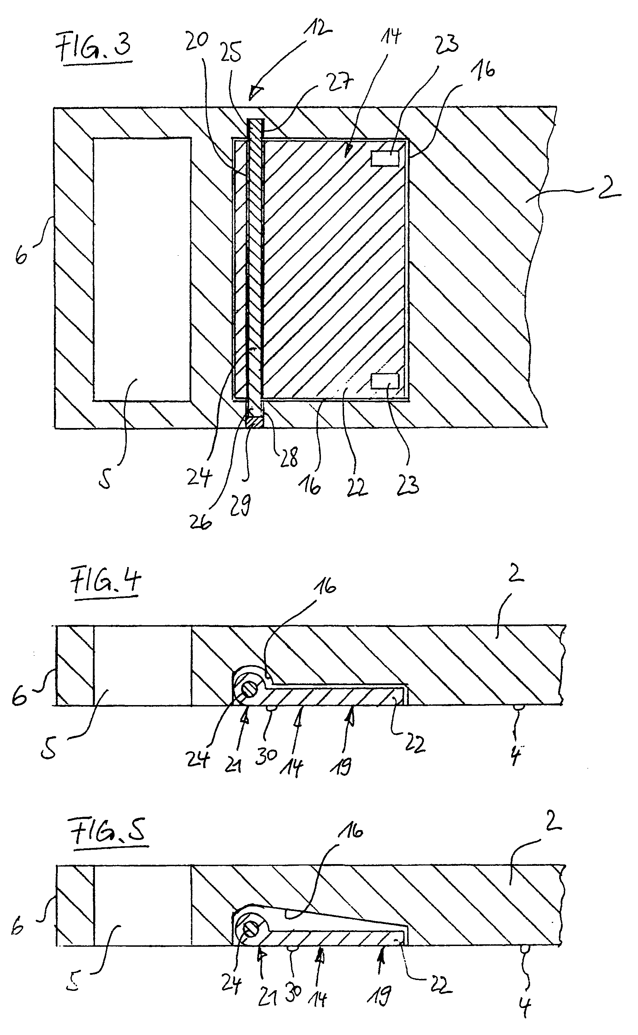

In Fig. 3 ist das Klappteil 14 vollständig in der Ausnehmung 16 versenkt. In die Längsbohrung 20 des Tragteils 18 ist jeweils ein Bolzen 24 durchgesteckt, wobei seine beiden aus dem Tragteil 18 herausragenden Enden 25, 26 jeweils in einer oberen und einer unteren, von der Ausnehmung 16 der Seitenwand 2 ausgehende Bohrungen 27, 28 aufgenommen werden. Die obere Bohrung 27 ist hier als Sackbohrung, die untere Bohrung 28 als Durchgangsbohrung ausgestaltet. Nach dem Einsetzen des Klappteils 14 und dem Durch- bzw. Einschieben des Bolzens 24 in die untere Bohrung 28, in die Längsbohrung 20 sowie in die obere Bohrung 27 wird eben die Durchgangsbohrung, d.h. die untere Bohrung 28, zur Fixierung des Bolzens 24 durch beispielsweise einen angeschweißten Stopfen 29, eine Schraube oder dergleichen wieder verschlossen. Die Flachseite 22 ist hier mit zwei in Form von Langlöchern vorgesehenen Querbohrungen 23 versehen. Diese Querbohrungen 23 sind jeweils in von dem Tragteil 18 abgewandten Eckbereichen der Flachseite 21 angeordnet. Das Klappteil 14 ist somit über durch die Querbohrungen 23 des Befestigungsteils 19 durchsteckbare Schrauben oder dergleichen mit einem - nicht dargestellten - das Gehäuse 1 aufnehmenden Rahmen- oder Wandteil verbindbar.

Schließlich zeigen die Fig. 4 und 5 noch, daß die Außenseite 30 des Klappteils 14 mit der Außenseite 4 der Seitenwand 2 fluchtet. Während nach Fig. 4 die Ausnehmung 16 der Seitenwand 2 etwa der Form des darin aufgenommenen Klappteils 14 entspricht, ist gemäß Fig. 5 die Ausnehmung 16 der Seitenwand 2 nicht vollständig an die Form des darin aufgenommenen Klappteils 14 angepaßt, sondern weist vielmehr eine schräg zur Rückseite 9 der Seitenwand 2 verlaufende Form auf.

## Patentansprüche

1. Gehäuse, insbesondere Baugruppenträger, mit zwei Seitenwänden, wenigstens einer oberen und einer unteren mit den beiden Seitenwänden verbundenen und diese zueinander auf Abstand haltenden Stützstreben oder dergleichen, und zwei, jeweils etwa senkrecht an der Außenseite einer jeden Seitenwand in einem stirnseitig nahen Bereich anbringbaren Befestigungsmitteln,
   **dadurch gekennzeichnet,**
   daß an jeder Seitenwand (2) an ihrer Außenseite (5) im stirnseitig nahen Bereich (12) ein als Befestigungsmittel vorgesehenes Klappteil (14) angeordnet ist.

2. Gehäuse nach Anspruch 1, dadurch gekennzeichnet, daß das Klappteil (14) jeweils in einer an der Außenseite (4) der jeweiligen Seitenwand (2) vorgesehenen Ausnehmung (16) versenkbar aufgenommen ist.

3. Gehäuse nach Anspruch 1 oder 2, dadurch gekennzeichnet, daß das Klappteil (14) jeweils einteilig ausgebildet ist und einen Trag- (18) sowie Befestigungsteil (19) aufweist.

4. Gehäuse nach Anspruch 3, dadurch gekennzeichnet, daß der Tragteil (18) jeweils aus einem etwa parallel zur Stirnseite (6) der jeweiligen Seitenwand (2) verlaufenden und mit einer Längsbohrung (20) versehenen Wulst (21) und der Befestigungsteil (19) jeweils aus einer sich hieran anschließenden, zur Rückseite (9) der jeweiligen Seitenwand (2) verlaufenden und mit wenigstens einer Querbohrung (23) versehenen Flachseite (22) besteht.

5. Gehäuse nach einem der Ansprüche 1 bis 4, dadurch gekennzeichnet, daß das Klappteil (14) jeweils über einen in die Längsbohrung (20) des Tragteils (18) durchsteckbaren Bolzens (24) in der Ausnehmung (16) der jeweiligen Seitenwand (2) verschwenkbar gehalten ist.

6. Gehäuse nach Anspruch 5, dadurch gekennzeichnet, daß die aus dem Tragteil (18) herausstehenden Enden (25, 26) des jeweiligen Bolzens (24) in einer oberen und einer unteren, von der Ausnehmung (16) der jeweiligen Seitenwand (2) ausgehende Bohrung (27, 28) einsteckbar sind.

7. Gehäuse nach Anspruch 6, dadurch gekennzeichnet, daß eine der beiden Bohrungen (27, 28) als Sackbohrung, die andere als Durchgangsbohrung ausgestaltet ist.

8. Gehäuse nach einem der Ansprüche 1 bis 7, dadurch gekennzeichnet, daß das Klappteil (14) jeweils über eine durch die Querbohrung (23) des Befestigungsteils (19) durchsteckbare Schraube oder dergleichen mit einem das Gehäuse (1) aufnehmenden Rahmen- oder Wandteil oder ähnlichem verbindbar ist.

9. Gehäuse nach einem der Ansprüche 1 bis 8, dadurch gekennzeichnet, daß das Klappteil (14) jeweils zusammen mit dessen Längs- (20) und/oder Querbohrung/en (23) stranggepreßt ist.

10. Gehäuse nach einem der Ansprüche 1 bis 9, dadurch gekennzeichnet, daß die Außenseite (30) des Klappteils (14) jeweils mit der Außenseite (4) der jeweiligen Seitenwand (2) fluchtet.

11. Gehäuse nach einem der Ansprüche 1 bis 10, dadurch gekennzeichnet, daß die Ausnehmung ( 16) der jeweiligen Seitenwand (2) etwa der Form des darin aufgenommenen Klappteils (14) angepaßt ist.

FIG.1

FIG.2

FIG. 3

FIG. 4

FIG. 5

Europäisches
Patentamt

**EUROPÄISCHER RECHERCHENBERICHT**

Nummer der Anmeldung

EP 90125199.1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.⁵) |
|---|---|---|---|
| A | <u>EP - A1 - 0 018 439</u><br>(SIEMENS)<br>  * Zusammenfassung; Fig. 1-3 *<br>  -- | 1-11 | H 05 K 5/02 |
| A | <u>EP - A2/A3 - 0 276 757</u><br>(AMERICAN TELEPHONE)<br>  * Zusammenfassung; Fig. 1 *<br>  ---- | 1-11 | |

RECHERCHIERTE
SACHGEBIETE (Int. Cl.⁵)

H 05 K 5/00
H 05 K 7/00

Der vorliegende Recherchenbericht wurde für alle Patentansprüche erstellt.

| Recherchenort | Abschlußdatum der Recherche | Prüfer |
|---|---|---|
| WIEN | 27-02-1991 | VAKIL |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument